# EUROPÄISCHE PATENTSCHRIFT

(11) **EP 1 926 198 B1**
(45) Veröffentlichungstag und Bekanntmachung des Hinweises auf die Patenterteilung: **04.05.2016**
(21) Anmeldenummer: 07020785.7
(22) Anmeldetag: 24.10.2007
(51) Int. Cl.: H02M 1/08, H03K 17/16, H03K 17/687, H03K 19/0185

(54) **Ansteuerschaltung mit BOT-Levelshifter zur Übertragung eines Eingangssignals und zugeordnetes Verfahren**
Driver circuit with BOT level shifter for transmitting an input signal and assigned method
Circuit de commande avec un dispositif de décalage de niveau de tension

(30) Priorität: 28.10.2006 DE 102006050913
(43) Veröffentlichungstag der Anmeldung: 28.05.2008
(73) Patentinhaber: SEMIKRON Elektronik GmbH & Co. KG, 90431 Nürnberg (DE)
(72) Erfinder: Herzer, Reinhard, Dr., 98693 Ilmenau (DE); Rossberg, Matthias, 98693 Ilmenau (DE); Vogler, Bastian, 98693 Ilmenau (DE)

(56) Entgegenhaltungen:
- DE-A1- 10 241 711
- US-B1- 6 222 385

## Beschreibung

Die Erfindung beschreibt eine Ansteuerschaltung, und ein zugeordnetes Verfahren, mit Levelshifter zur Übertragung eines Eingangssignals von einer Ansteuerlogik zu einem Treiber. Derartige Ansteuerschaltungen werden in leistungselektronischen Systemen benötigt um Leistungshalbleiterschatter anzusteuern, die als Einzelschalter oder in einer Brückenschaltung angeordnet sind. Derartige Brückenschaltungen sind als Ein-, Zwei-, oder Dreiphasen-Brückenschaltungen bekannt, wobei die einphasige sog. Halbbrücke einen Grundbaustein einer Vielzahl von leistungselektronischen Schaltungen darstellt. In einer Halbbrückenschaltung sind zwei Leistungsschalter, ein erster sog. TOP-Schalter und ein zweiter sog. BOT- Schalter in einer Reihenschaltung angeordnet.

Eine derartige Halbbrücke weist in der Regel eine Verbindung zu einem Gleichstromzwischenkreis auf. Der Ausgang, typischerweise der Wechselspannungsanschluss der Halbbrücke ist meist mit einer Last verbunden. Die Ansteuerschaltung besteht in der Regel aus mehreren Teilschaltungen bzw. Funktionsblöcken. Das Steuersignal wird in einer ersten Teilschaltung, der Ansteuerlogik, aufbereitet und über weitere Komponenten den Treiberschaltungen und schließlich dem Steuereingang des jeweiligen Leistungsschalters zugeführt.

Bei höheren Zwischenkreisspannungen, beispielhaft größer 100V, wird meist die Ansteuerlogik potentialmäßig von den Treiberschaltungen getrennt, da sich die zugehörigen Leistungsschalter auf unterschiedlichem Potential befinden und somit eine spannungsmäßige Isolation unumgänglich ist. Diese Trennung gilt zumindest für den TOP-Schalter, wird aber bei höheren Leistungen auch für den BOT- Schalter auf Grund eines möglichen Verrisses des Massepotentials beim Schalten ausgeführt. Eine derartige Trennung kann zum Beispiel durch Impulsübertrager, durch Optokoppler bzw. Lichtwellenleiter (galvanische Trennung) oder mit Hilfe integrierter Schaltungstechnik in einem HVIC (High Voltage Integrated Circuit) realisiert werden. Letztere Variante wird, aufgrund verschiedener Vorteile, wie geringe Abmessungen, niedriger Preis und lange Lebensdauer, mit zunehmender Häufigkeit eingesetzt. Gleichzeitig bieten HVICs die Möglichkeit, ein Hochspannungsbauelement, mit einer Durchbruchspannung größer oder gleich der Zwischenkreisspannung zu integrieren, welche in Schaltkreisen zur Signalpegelumsetzung, in sog. Levelshiftern, eingesetzt werden kann. Üblicherweise wird für diese ein lateraler Hochspannungs- MOSFET verwendet.

Der beschriebene Levelshifter ist Teil der Ansteuerschaltung und vorzugsweise ausgeführt als eine integrierte Schaltungsanordnung. Er dient der Übertragung eines Signals von einem Schaltungsteil mit einem definierten Bezugspotential zu einem Schaltungsteil mit einem zeitweise höheren oder niedrigeren Bezugspotential oder umgekehrt. Eine solche Anordnung wird zur integrierten und potentialgetrennten Ansteuerung von Leistungshalbleitern benötigt.

Es sind zwei grundsätzliche Isolationstechnologien zur Ausbildung von Levelshiftern bei HVICs bekannt. Einerseits die SOI-(Silicon on Insulator) Technologien und andererseits pn- isolierte Technologien (Junction Isolation). Die SOI- Technologie bietet eine dielektrische Isolation von Bauelementen und Bauelementgruppen, steht aber derzeit nur bis 800V Spannungsfestigkeit zur Verfügung. Die SOI- Substratwafer sind deutlich teurer als Standardsubstrate, allerdings werden die Kosten durch eine Reihe technischer Vorteile sowie erhebliche Prozessvereinfachungen kompensiert, die sich aus der dielektrischen Isolation ergeben. Bei pn- isolierten Technologien wird die Sperrspannung durch einen sperrgepolten pn- Übergang aufgenommen. Diese Technik steht derzeit bis 1200V zur Verfügung. Die Herstellung ist allerdings sehr aufwendig und somit kostenintensiv. Weiterhin gibt es technische Probleme, beispielhaft mit Leckströmen und Latch- up Effekten u.a. bei höheren Temperaturen, wie beispielhaft mehr als 125°C Betriebstemperatur, sowie bei Verriss des Massepotentials bei schnellen dynamischen Vorgängen.

Bei integrierten Ansteuerschaltungen wird nach dem Stand der Technik bislang die Levelshifterübertragung der Ansteuersignale von der Ansteuerlogik zum TOP- Treiber häufig eingesetzt. Dies ist notwendig, da der TOP- Treiber, im Unterschied zum BOT-Treiber, phasenweise auf einem erhöhten Bezugspotential liegt. Nach dem Stand der Technik erfolgt die Signalübertragung von der Ansteuerseite zum TOP-Treiber mittels gepulster (dynamischer) und differentieller Übertragung, d.h. aus dem zu übertragenden Signal werden ansteuerseitig Ein- und Ausschaltpulse erzeugt, die über den jeweiligen Levelshifter auf den TOP- Treiber übertragen werden. Dies erhöht die Übertragungssicherheit und senkt den Leistungsbedarf der Schaltung. Es sind verschiedene integrierte Levelshiftertopologien bekannt. Die einfachste Topologie, bestehend aus einem HV- Transistor mit entsprechender Sperrfähigkeit und einem Widerstand, die untereinander in Reihe geschaltet sind. Wird ein Signal auf das Gate des HV- Transistors gegeben schaltet dieser ein. Der dadurch erzeugte Querstrom durch den Levelshifter, verursacht einen Spannungsabfall über dem Widerstand, der als Signal von einer Auswerteschaltung erfasst werden kann.

In DE 101 52 930 A1 wird eine erweiterte Levelshiftertopologie offenbart, bei der das Ansteuersignal schrittweise, mittels n gleichartig kaskadiert geschalteter bekannter Levelshifter, über n-1 Zwischenpotentiale übertragen wird. Damit lassen sich Transistoren einsetzen, die nur den n- ten Teil der geforderten Sperrfähigkeit des gesamten Levelshifters besitzen. Sind Transistoren mit der geforderten Sperrfähigkeit verfügbar kann die Sperrfähigkeit des Levelshifters um den Faktor n erhöht werden.

Die nicht vorveröffentlichte DE 10 2006 037 336 offenbart einen Levelshifter ausgeführt als eine Reihenschaltung aus n in Reihe geschalteten HV-Transistoren. Diese Topologie weist die Vorteile auf, dass gegenüber DE 101 52 930 A1 zum einen der Leistungsverbrauch und zum anderen der Schaltungsaufwand verringert sind. Dies hat einen geringeren Platzbedarf und somit auch geringere Kosten zur Folge.

Die US 6,222,385 B1 offenbart eine Schaltungsanordnung mit je einem ersten (UP) und einem zweiten (DOWN) Levelshifter, wobei ein Komparator das Potential des Ausgangs des zweiten Levelshifters mit einem Referenzsignal vergleicht. Basieren hierauf wird der erste oder der zweite Levelshifter angesteuert und ein Eingangssignal hierüber übertragen. Hierbei ist lediglich eine Pegelwandlung offenbart, wobei beide Seiten, vor und nach dem Levelshifter, das gleiche Bezugpotential aufweisen.

Allen bekannten Topologien ist gemein, dass bei komplementärem Aufbau des Levelshifters auch eine Signalübertragung von einem Schaltungsteil mit einem hohen Bezugspotential zu einem Schaltungsteil mit einem niedrigen Bezugspotential möglich ist. Diese Eigenschaft kann für eine Signalrückübertragung vom TOP- Treiber zur Ansteuerlogik genutzt werden, wie es beispielhaft in der DE 102 41 771 A1 offenbart ist.

Nach dem Stand der Technik werden bei integrierten Ansteuerschaltungen die Ansteuerlogik (Primärseite) und der BOT- Treiber (Sekundärseite) meist auf gleiches oder nur um wenige Volt voneinander abweichendes Bezugspotential gelegt, so dass keine
Signalübertragung über Levelshifter notwendig ist. Dabei werden die Anschlüsse für das primärseitige bzw. sekundärseitige Bezugspotential meist extern kurzgeschlossen. Durch modul- und systeminterne Induktivitäten, beispielhaft Leitungsinduktivitäten, kann es jedoch während des Schaltens der Leistungsbauelemente zu einem starken Verriss des Bezugspotentials der BOT- Treiber in positiver oder negativer Richtung kommen. Dies tritt in besonders starkem Maße in Systemen mittlerer und hoher Leistung auf, bei denen große Ströme, beispielhaft größer 50A, geschaltet werden. Die Potentialdifferenz kann dabei Werte annehmen, die über die Sperrspannung der Gateoxide der verwendeten Transistoren, beispielhaft größer 20V, hinausgehen. Junction Isolation Technologien weisen den Nachteil auf, dass es bei einem entsprechenden Verriss des Bezugspotentials in negative Richtung zum Zünden parasitärer Thyristorstrukturen, sog. Latch-up, kommen kann. Dies führt zum Funktionsverlust und eventuell zur Zerstörung der betroffenen Bauelemente. Diese Einschränkung ist, bedingt durch die dielektrische Isolation der Bauelemente, bei SOI- Technologien nicht gegeben.

Der Erfindung liegt die Aufgabe zugrunde eine Ansteuerschaltung vorzugsweise in Form einer zumindest teilweise monolithisch integrierten Schaltung vorzustellen, wobei eine Signalübertragung zwischen Schaltungsteilen möglich ist, deren Bezugspotentialdifferenz über der Spannungsfestigkeit der Gateoxide der verwendeten Transistoren liegt.

Die Aufgabe wird erfindungsgemäß gelöst, durch die Maßnahmen der Merkmale der Ansprüche 1 und 9. Bevorzugte Ausführungsformen sind in den Unteransprüchen beschrieben.

Der erfinderische Gedanke geht aus von einer Ansteuerschaltung mit einem Levelshifter zur vorzugsweise unidirektionalen Übertragung eines Signals von einem ersten Schaltungsteil mit erstem Bezugspotential zu einem zweiten Schaltungsteil mit zweitem Potential. Erfindungsgemäß wird diese Ansteuerschaltung weitergebildet durch einen BOT- Levelshifter zur potentialtrennenden Übertragung dieses Eingangssignal. Der BOT- Levelshifter selbst ist ausgebildet als eine Anordnung zweier unabhängig arbeitender Übertragungszweige, dem UP- und dem DOWN- Levelshifterzweig sowie einer nachgeschalteten Signalauswerteschaltung.

Der UP- Levelshifterzweig überträgt das anliegende Eingangssignal von der Primär- zur Sekundärseite, wenn das sekundärseitige Bezugspotential gleich oder größer ist als das primärseitige Bezugspotential. Der DOWN- Levelshifterzweig überträgt das anliegende Eingangssignal von der Primär- zur Sekundärseite, wenn das sekundärseitige Bezugspotential gleich oder kleiner ist als das primärseitige Bezugspotential. Es wird somit sowohl bei höherem als auch bei niedrigerem sekundärseitigem Bezugspotential gegenüber dem primärseitigen Bezugspotential mindestens ein gültiges Signal übertragen. Die Signalauswerteschaltung erfasst die Signale des jeweiligen Ausgangs des UP- bzw. DOWN- Levelshifterzweiges und rekonstruiert das übertragene Signal auf der Sekundärseite.

Vorzugsweise erfolgt die Signalübertragung am erfindungsgemäßen Levelshifter statisch, d.h. das zu übertragende Signal wird kontinuierlich von der Primärseite zur Sekundärseite übertragen, und zum anderen querstromfrei im statischen Zustand, d.h. es fließt nur während einer Zustandsänderung kurzzeitig ein Querstrom durch einen Levelshifterzweig. Diese Übertragung stellt einen Vorteil zur gepulsten Übertragung nach dem Stand der Technik dar, da eine aufwendige Erzeugung von Übertragungspulsen nicht benötigt wird und die Zeitspanne während derer ein Querstrom fließt reduziert werden kann. Somit kann zum einen der Leistungsverbrauch und zum anderen der Schaltungsaufwand gegenüber dem Stand der Technik verringert werden. Dies hat einen geringeren Platz- und somit auch einen geringeren Kostenbedarf zur Folge. Durch die kontinuierliche Übertragung des Signals ist weiterhin eine höhere Störsicherheit gegeben, da auf einen Pulsflankenspeicher (Flipflop) auf der Sekundärseite verzichtet werden kann.

Weiterhin ist der Einsatz der Ansteuerschaltung im Vergleich zum Stand der Technik auch in Systemen höherer Leistung mit größeren Potentialunterschieden zwischen der Primärseite und der Sekundärseite bzw. dem BOT- Leistungsschalter der Sekundärseite möglich.

Das erfindungsgemäße Verfahren zur Übertragung eines Eingangssignals von der Ansteuerlogik zu einem BOT- Treiber innerhalb einer Ansteuerschaltung mit BOT-Levelshifter ist dadurch gekennzeichnet, dass die Signalauswerteschaltung ein Ausgangssignal an den BOT- Treiber übergibt, wenn entweder der UP- oder der DOWN- oder beide Levelshifterzweige ein Signal an den jeweils zugeordneten Eingang der Signalauswerteschaltung abgeben.

Die erfinderische Lösung wird an Hand der Fig. 1 bis 4 weiter erläutert.
Fig. 1 zeigt eine monolithisch integrierte Ansteuerschaltung nach dem Stand der Technik.
Fig. 2 zeigt eine erfindungsgemäße monolithisch integrierte Ansteuerschaltung mit einem BOT- Levelshifter.
Fig. 3 zeigt einen BOT- Levelshifter einer erfindungsgemäßen Ansteuerschaltung.
Fig. 4 zeigt Simulationsergebnisse des erfindungsgemäßen Verfahrens.

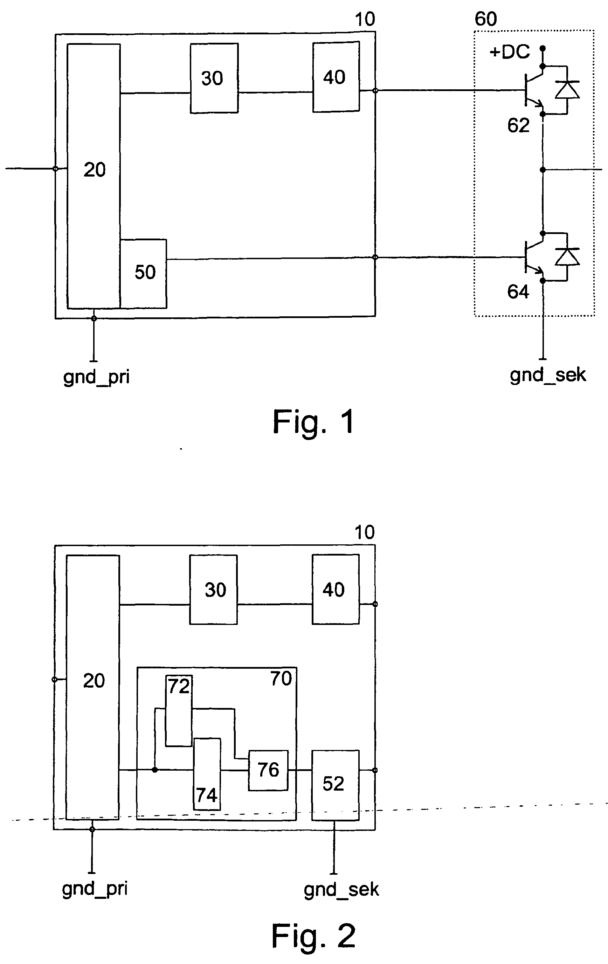

Fig. 1 zeigt eine monolithisch integrierte Ansteuerschaltung (10) nach dem Stand der Technik mit einer Halbbrückenschaltung (60). Diese Halbbrückenschaltung (60) weist gemäß dem Stand der Technik einen BOT- (64) und einen TOP Leistungsschalter (62) auf, die hier jeweils als ein IGBT mit antiparallel geschalteter Diode ausgebildet sind. Der BOT- Schalter (64) liegt auf dem Bezugspotential (gnd_sek) der Sekundärseite, welches bei Applikationen mit kleinen Leitungsinduktivitäten nahezu gleich dem Bezugspotential (gnd_pri) der Primärseite ist. Das Bezugspotential (gnd_pri) der Primärseite ist das Bezugspotential der Ansteuerschaltung (10).

Die Ansteuerschaltung selbst weist eine Ansteuerlogik (20), einen TOP-Levelshifter (30) mit nachgeschaltetem TOP- Treiber (40) sowie einen BOT- Treiber (50) auf. Der BOT- Treiber (50) liegt hierbei auf dem Bezugspotential der Ansteuerlogik (20).

Fig. 2 zeigt eine erfindungsgemäße monolithisch integrierte Ansteuerschaltung mit einem BOT- Levelshifter (70). Dieser bildet die erfindungsgemäße Weiterbildung des Standes der Technik gemäß Fig. 1. Der BOT- Schalter (64, Fig. 1) liegt auf dem Bezugspotential (gnd_sek) der Sekundärseite, welches bei Applikationen mit großen Leitungsinduktivitäten phasenweise unterschiedlich zum Bezugspotential (gnd_pri) der Primärseite ist. Der BOT- Levelshifter (70) besteht hierbei aus einem UP-Levelshifterzweig (72), einem DOWN- Levelshifterzweig (74) und einer diesen nachgeschalteten Signalauswerteschaltung (76), die auch auf dem Bezugspotential (gnd_sek) der Sekundärseite liegt. Der Ausgang der Signalauswerteschaltung (76) liegt am Eingang des BOT- Treibers (52).

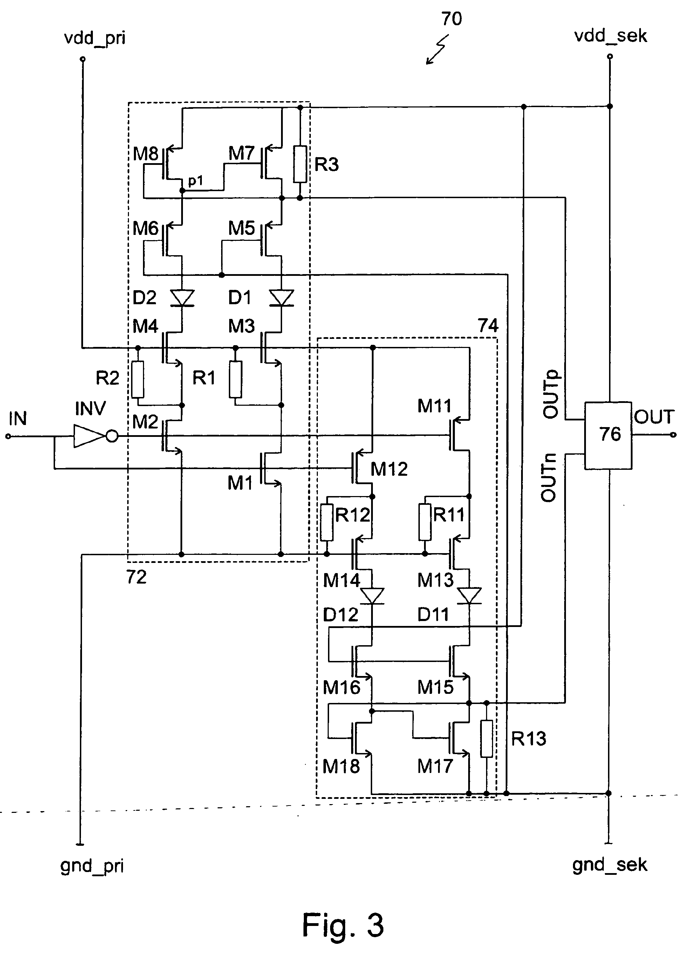

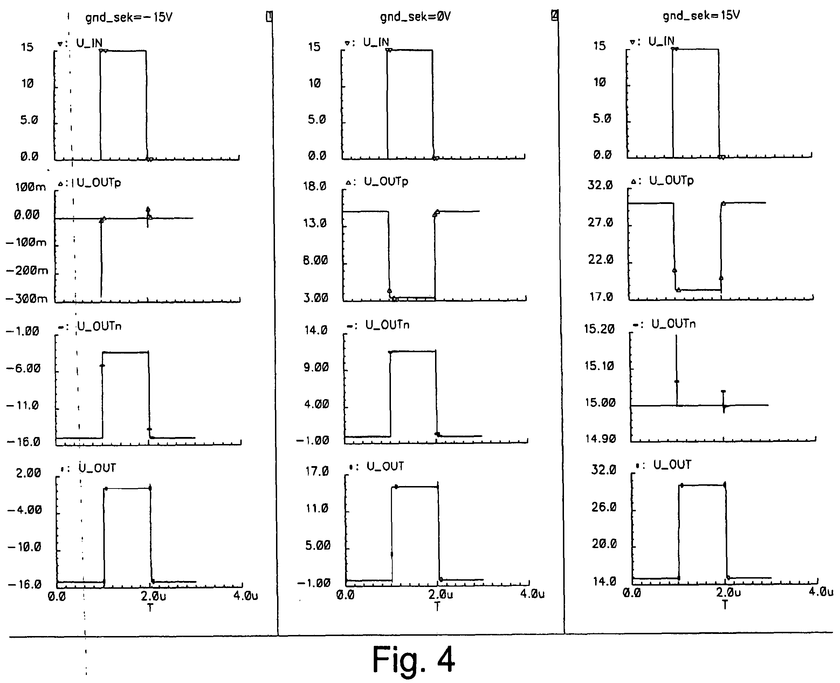

Fig. 3 zeigt einen BOT- Levelshifter (70) einer erfindungsgemäßen Ansteuerschaltung im Detail. Fig. 4 zeigt hierzu die Simulationsergebnisse des erfindungsgemäßen Verfahrens.

Der BOT- Levelshifter (70) weist hierbei zwei symmetrische Teile, den UP- (72) und DOWN- (74) Levelshifterzweig auf. Diese sind prinzipiell in Aufbau und Funktionsweise gleich, allerdings werden jeweils komplementäre Transistoren verwendet, d.h. n-Kanal Transistoren im UP- Levelshifterzweig werden durch p-Kanal Transistoren im DOWN- Levelshifterzweig ausgeführt und umgekehrt. Anschlüsse, die im UP-Levelshifterzweig (72) an einer Versorgungsspannung anliegen, werden im DOWN-Levelshifterzweig (74) an das entsprechende Bezugspotential angelegt und umgekehrt. Der Aufbau des UP- und DOWN- Levelshifterzweiges wird im Weiteren erläutert.

Der UP- Levelshifterzweig besteht seinerseits aus zwei identischen Teilzweigen mit den Schalttransistoren M1 bzw. M2, einem Transistor M3 bzw. M4 jeweils vom n-Kanal-Typ, einer Diode D1 bzw. D2, sowie den weiteren Transistoren M5 bzw. M6 und M7 bzw. M8 jeweils vom p-Kanal-Typ. Diese Bauelemente des jeweiligen Teilzweiges sind in Reihe geschaltet. Die Sourceanschlüsse der Schalttransistoren M1 und M2 sind an das primärseitige Bezugspotential (gnd_pri) angeschlossen. Die Gateanschlüsse von M3 und M4 sind an den primärseitigen Versorgungsspannungsanschluss (vdd_pri) angeschlossen. Die Sourceanschlüsse von M7 und M8 sind an den sekundärseitigen Versorgungsspannungsanschluss (vdd_sek) und die Gateanschlüsse von M5 und M6 an das sekundärseitige Bezugspotential (gnd_sek) angeschlossen. Die Gateanschlüsse von M7 und M8 sind am Drain von M8 bzw. M7 angeschlossen, d.h. am Drain des Transistors des parallelen Zweiges (kreuzweise Verkopplung). Drain von M7 bildet den Ausgang (OUTp) des UP- Levelshifterzweiges (72) und ist an einen ersten Eingang der Signalauswerteschaltung (76) angeschlossen.

Analog besteht jeder Teilzweig des DOWN- Levelshifterzweiges (74) aus einem Schalttransistor M11 bzw. M12, und einem Transistor M13 bzw. M14 jeweils vom p-Kanal-Typ, einer Diode D11 bzw. D12, sowie den Transistoren M15 bzw. M16 und M17 bzw. M18 jeweils vom n-Kanal-Typ. Auch diese Bauelemente des jeweiligen Teilzweiges sind in Reihe geschaltet. Die Sourceanschlüsse der Schalttransistoren M11 und M12 sind an den primärseitigen Versorgungsspannungsanschluss (vdd_pri) angeschlossen. Die Gateanschlüsse von M13 und M14 sind an das primärseitige Bezugspotential (gnd_pri) angeschlossen. Die Sourceanschlüsse von M17 und M18 sind an das sekundärseitige Bezugspotential (gnd_sek) und die Gateanschlüsse von M15 und M16 an den sekundärseitigen Versorgungsspannungsanschluss (vdd_sek) angeschlossen. Die Gateanschlüsse von M17 und M18 sind am Drain von M18 bzw. M17 angeschlossen, d.h. am Drain des Transistors des parallelen Zweiges (kreuzweise Verkopplung). Drain von M17 bildet den Ausgang (OUTn) des DOWN- Levelshifterzweiges (74) und ist an einen zweiten Eingang der Signalauswerteschaltung (76) angeschlossen.

Im Folgenden wird die Funktionsweise des UP- Levelshifterzweiges (72) für den Fall beschrieben, dass das sekundärseitige Bezugspotential (grd_sek) nahezu gleich oder größer ist als das primärseitige Bezugspotential (gnd_pri). Für den DOWN-Levelshifterzweig (74) gilt das Beschriebene in gleicher Weise für umgekehrte Polarität. Auf das Gate des Schalttransistors M1 wird ein von der Ansteuerlogik aufbereitetes Steuersignal (IN), beispielhaft ein rechteckförmiger Impuls, gegeben. Auf das Gate des Schalttransistors M2 wird das dazu invertierte Signal gegeben, das durch den Inverter (INV) erzeugt wird. Die Steuersignale bewirken ein exklusives Einschalten jeweils eines der Transistoren M1 und M2. Beim Einschalten von M1 wird ebenfalls der Transistor M3 geöffnet (Kaskodeprinzip).

Die Diode D1 ist in Durchlassrichtung gepolt. Das Drainpotential des Transistors M7 liegt zu diesem Zeitpunkt nahe der sekundärseitigen Versorgungsspannung (vdd_sek), da die Gate- Source- Spannung von M7 negativer (betragsmäßig größer) als seine Schwellspannung ist und der Transistor somit leitend (ein) ist. Dies liegt in der Tatsache begründet, dass zu diesem Zeitpunkt im zweiten Teilzweig M2, M4, M6, M8 und D2, die Transistoren M2, M4 und M6 leitend (ein) sind und der Transistor M8 nicht leitend (aus) ist. Der Knoten p1 (Gate- Potential von M7) liegt daher nahe dem sekundärseitigen Bezugspotential (gnd_sek). Daraus folgt, dass auch M5 eine Gate- Source- Spannung hat, die kleiner als die Schwellspannung ist. Somit ist M5 auch leitfähig (ein).

Im Teilzweig M1, M3, M5, M7 und D1 baut sich ein Querstrom auf. Dadurch sinkt das Potential am Ausgang (OUTp) des UP- Levelshifterszweigs (72). Somit verringert sich auch die Gate- Source- Spannung von M8. Unterschreitet seine Gate- Source-Spannung die Schwellspannung, so wird M8 leitfähig (ein) und das Potential am Knoten p1 steigt an, was wiederum dazu führt, dass die Gate- Source- Spannung von M7 ansteigt, bis diese positiver als die Schwellspannung wird und M7 zu sperren beginnt (aus). Damit sinkt auch das Potential am Ausgangsknoten OUTp weiter.

Durch die kreuzweise Verkopplung der Transistoren M7 und M8 wirken die beiden Teilzweige wie beschrieben als Kippstufe. Durch die positive Gegenkopplung (Mitkopplung) beider Teilzweige wird die Schaltzeit der Stufe, also die Zeitspanne während der nennenswerte Schaltströme fließen können, sehr klein. Dies führt zu einem geringen Leistungsverbrauch des Levelshifters.

Das minimale Potential am Ausgang (OUTp) bzw. am Knoten (p1) stellt sich im Einschaltzustand statisch derart ein, dass die Schwellspannung der Transistoren M5 bzw. M6 annähernd erreicht wird. Dadurch fließt nur während des Umschaltens ein Querstrom durch den jeweils einschaltenden Teilzweig. Sonst verhindern die sperrenden (ausgeschalteten) Transistoren M5 bzw. M6 einen weiteren Stromfluss im eingeschalteten Levelshifterzweig. Der gesamte UP- Levelshifterzweig (72) arbeitet somit statisch querstromfrei.

Da die Gateanschlüsse von M5 und M6 auf dem sekundärseitigen Bezugspotential (gnd_sek) liegen und die niedrigsten Potentiale am Ausgang OUTp sowie am Knoten p1 auf einen Wert begrenzt werden, der im Bereich von (gnd_sek) abzüglich der Schwellspannung von M5 bzw. M6 liegt, kann die zulässige Gate- Source-Spannung der Transistoren M7 und M8 nicht überschritten werden sofern die sekundärseitige Betriebsspannung, d.h. die Potentialdifferenz (vdd_sek minus gnd_sek), den Betrag der zulässigen Gate- Source- Spannung nicht überschreiten. Auch bei allen weiteren Transistoren überschreiten die Beträge der Gate- Source- Spannung nicht die jeweilige primärseitige (vdd_pri) bzw. sekundärseitige (vdd_sek) Betriebsspannung. Somit haben auch große Spannungsdifferenzen, die zwischen den Bezugpotentialen von Primär- und Sekundärseite auftreten können, keine Belastung der Gateoxide der verwendeten Transistoren zur Folge. Für den DOWN- Levelshifterzweig gelten die Aussagen analog für ein Bezugspotential (gnd_sek) der Sekundärseite, das niedriger ist als das Bezugspotential (gnd_pri) der Primärseite.

Die maximal zulässige Differenz zwischen primärseitigem und sekundärseitigem Bezugspotential ist durch die Drain- Source- Spannungsfestigkeit der Transistoren M3 bis M6 gegeben. Um Potentialdifferenzen zu überwinden die im Bereich der Betriebsspannung liegen, beispielhaft 15V, können oftmals Niederspannungstransistoren für M3 bis M6 eingesetzt werden. Für höhere Spannungen finden Mittelspannungs- bzw. Hochspannungstransistoren Anwendung. Für den DOWN- Levelshifterzweig gelten die Aussagen analog für ein Bezugspotential (gnd_sek) der Sekundärseite, das niedriger ist als das Bezugspotential (gnd_pri) der Primärseite.

Um bei einem nicht anliegenden Signal (IN) am Eingang des BOT- Levelshifters (70), beispielhaft beim Einschalten oder Fehlen der primärseitigen Versorgungsspannung (vdd_pri), ein definiertes Ausschaltsignal (OUT) am Ausgang des Levelshifters (70) zu gewährleisten, wird der pull- up- Widerstand (R3) zwischen Betriebsspannung (vdd_sek) der Sekundärseite und dem Ausgang (OUTp) geschaltet. Die hochohmigen Widerstände (R1 und R2) werden an den Betriebsspannungsanschluss (vdd_pri) der Primärseite und jeweils an das Source der Transistoren M3 bzw. M4 angeschlossen. Damit sind bei undefiniertem Zustand der Primärseite, auch die Transistoren M3 und M4 definiert ausgeschaltet. Die Widerstände R11, R12 und R13 übernehmen im DOWN-Levelshifterzweig (74) die analoge Funktion.

Der Schaltzustand am Ausgang des UP- Levelshifterzweiges (72) wird durch die Signalauswerteschaltung erfasst und zusammen mit dem Schaltzustand am Ausgang des DOWN- Levelshifterzweiges (74) ausgewertet. Das erzeugte Ausgangssignal (OUT) wird auf den BOT- Treiber (52) gegeben.

Die Signalübertragung über den UP- Levelshifterzweig (72) erfolgt nur wenn das Bezugspotential (gnd_sek) der Sekundärseite höher, genauso hoch oder geringfügig niedriger als das Bezugspotential (gnd_pri) der Primärseite ist. Liegt das Bezugspotential (gnd_sek) der Sekundärseite unter einen bestimmten Wert, beispielhaft einige Volt, gegenüber der Primärseite, so wird die vorgegebene Einschaltschwelle, die in der Signalauswerteschaltung von einer Schwellwerterfassungsschaltung, beispielhaft ein Komparator oder Schmitt- Trigger, vorgegeben wird, nicht unterschritten. In diesem Fall wird kein Einschaltsignal übertragen. Die Spannung am Ausgang (OUTp) entspricht dann dem Ausschaltzustand (LOW). Sinkt das Potential der Sekundärseite soweit ab, dass die Drain- Bulk- Dioden der Transistoren M1 bis M8 in Durchlassrichtung gepolt wären, d.h. das sekundärseitige Versorgungspotential (vdd_sek) sinkt unter das primärseitige Bezugspotential (gnd_pri), dann sperren die Dioden D1 und D2 einen Stromfluss durch beide Teilzweige.

Analog erfolgt die Signalübertragung über den DOWN- Levelshifterzweig (74) nur, wenn das Bezugspotential (gnd_sek) der Sekundärseite kleiner, genauso hoch oder geringfügig höher als das Bezugspotential (gnd_pri) der Primärseite ist. Liegt das Bezugspotential (gnd_sek) der Sekundärseite über einem bestimmten Wert, beispielhaft einige Volt gegenüber der Primärseite, wird die vorgegebene Einschaltschwelle, die in der Signalauswerteschaltung von einer Schwellwerterfassungsschaltung, beispielhaft ein EM-Komparator oder Schmitt- Trigger, vorgegeben wird, nicht überschritten. In diesem Fall wird kein Einschaltsignal übertragen. Die Spannung (OUTn) am Ausgang entspricht dem Ausschaltzustand (HIGH). Steigt das Potential der Sekundärseite soweit an, dass die Drain- Bulk- Dioden der Transistoren M11 bis M18 in Durchlassrichtung gepolt wären, d.h. das sekundärseitige Bezugspotential (gnd_sek) steigt über das Potential der primärseitige Versorgungsspannung (vdd_pri), dann sperren die Dioden D11 und D12 einen Stromfluss durch beide Teilzweige.

Befindet sich das Bezugspotential (gnd_sek) der Sekundärseite innerhalb eines Bereiches einige Volt über- bzw. unterhalb des Bezugspotentials (gnd_pri) der Primärseite, dann übertragen sowohl der UP- (72) als auch der DOWN- (74) Levelshifterzweig gültige Signale von der Primär- auf die Sekundärseite. Durch diesen überlappenden Bereich ist eine sichere Signalübertragung auch unter Berücksichtigung von Exemplarstreuungen der Übertragungsschwellen, durch technologisch bedingte Schwankungen von Bauelementeparametern, sowie bei schnellen Änderungen des sekundärseitigen Bezugspotentials, gewährleistet. Dies erhöht die Störsicherheit des Levelshifters (70).

Die Signalauswerteschaltung (76) erzeugt ein gültiges Ansteuersignal (OUT) für den BOT- Treiber (52) wenn entweder ein Signal über den UP- Levelshifterzweig (72) oder den DOWN- Levelshifterzweig (74) oder über beide- Levelshifterzweige gleichzeitig übertragen wird (ODER- Verknüpfung).

In Fig. 4 ist das transiente Übertragungsverhalten des Levelshifters (70) gemäß Fig. 3 im Rahmen einer Simulation, bei negativem Bezugspotential der Sekundärseite (gnd_sek=-15V, links), bei gleichem Bezugspotential von Primär- und Sekundärseite (gnd_sek=0V, mitte) und bei positivem Bezugspotential der Sekundärseite (gnd_sek=15V, rechts), dargestellt. Das Bezugspotential (gnd_pri) der Primärseite liegt dabei immer auf Massepotential (0V). Es wurde jeweils das gleiche rechteckförmige Ansteuersignal U_{IN} auf den Eingang IN gegeben. Aus der Abbildung ist ersichtlich, dass bei gleichem Bezugspotential von Primär- und Sekundärseite (mitte) sowohl am Ausgang des UP- Levelshifterzweiges (U_{OUTp}) als auch am Ausgang des DOWN-Levelshifterzweiges (U_{OUTn}) ein übertragenes Signal erscheint, wohingegen bei negativem bzw. positiven Bezugspotential nur am Ausgang des jeweils zugeordneten Levelshifterzweiges ein übertragenes Signal erscheint und der Ausgang des entsprechenden komplementären Levelshifterzweiges im Ausschaltzustand verharrt. In allen drei Fällen erkennt die Signalauswerteschaltung, dass mindestens ein Signal über den UP- und/oder DOWN- Levelshifterzweig übertragen wurde und gibt ein gültiges Ausgangssignal U_{OUT} aus. Der Levelshifter (70) zeigt somit das gewünschte Verhalten.

## Patentansprüche

1. Ansteuerschaltung (10) mit BOT- Levelshifter (70) zur Übertragung eines Eingangssignals (IN) von einer Ansteuerlogik (20) mit primärseitigen Bezugspotential zu einem BOT- Treiber (52) mit vom primärseitigen Bezugspotential unabhängigen sekundärseitigem Bezugspotential, wobei der Levelshifter (70) ausgebildet ist als eine Anordnung eines UP- (72) und eines DOWN- (74) Levelshifterzweiges sowie einer nachgeschalteten Signalauswerteschaltung (76)
**dadurch gekennzeichnet,**
**dass** der UP- Levelshifterzweig (72) gebildet wird aus zwei Teilzweigen, die ihrerseits gebildet werden aus der seriellen Anordnung von je zwei n-Kanal Transistoren (M1, M3 bzw. M2, M4), wobei an M1 das Eingangssignal (IN) anliegt und an M2 das invertierte Eingangssignal anliegt, je einer Diode (D1 bzw. D2) und je zwei p-Kanal Transistoren (M5, M7 bzw. M6, M8)
und der DOWN- Levelshifterzweig (74) gebildet wird aus zwei Teilzweigen, die ihrerseits gebildet werden aus der seriellen Anordnung von je zwei p-Kanal Transistoren (M11, M13 bzw. M12, M14), wobei an M12 das Eingangssignal (IN) anliegt und an M11 das invertierte Eingangssignal anliegt, je einer Diode (D11 bzw. D12) und je zwei n-Kanal Transistoren (M15, M17 bzw. M16, M18).

2. Ansteuerschaltung (10) nach Anspruch 1,
wobei innerhalb des Levelshifters (70) der UP- Levelshifterzweig (72) im Wesentlichen komplementär zum DOWN- Levelshifterzweig (74) ausgebildet ist.

3. Ansteuerschaltung nach Anspruch 1,
wobei der Ausgang des UP- Levelshifterzweiges (72) und der Ausgang des DOWN-Levelshifterzweiges (74) mit den Eingängen der Signalauswerteschaltung (76) verbunden sind und der Ausgang (OUT) der Signalauswerteschaltung (76) das Eingangssignal für den BOT- Treiber (52) bildet.

4. Ansteuerschaltung nach Anspruch 1,
wobei die Ansteuerlogik (20), der Levelshifter (70) und der BOT- Treiber (52) monolithisch integriert sind.

5. Ansteuerschaltung nach Anspruch 1,
wobei durch die Verschaltung der Transistoren (M7, M8) eine Kippstufe, bestehend aus den Bauelementen (M1 bis M8, D1, D2) im UP- Levelshifterzweig (72), und durch die Verschaltung der Transistoren (M17, M18) eine Kippstufe, bestehend aus den Bauelementen (M11 bis M18, D11, D12) im DOWN- Levelshifterzweig (74), gebildet wird.

6. Ansteuerschaltung nach Anspruch 1,
wobei die Gates der Transistoren (M5, M6) mit dem Bezugspotential (gnd_sek) des BOT- Treibers (52) verbunden sind und die Gates der Transistoren (M15, M16) mit dem Versorgungspotential (vdd_sek) des BOT- Treibers (52) verbunden sind.

7. Verfahren zur Übertragung eines Eingangssignals (IN) von der Ansteuerlogik (20) zu einem BOT Treiber (52) innerhalb einer Ansteuerschaltung (10) mit BOT- Levelshifter (70) wobei der Levelshifter (70) ausgebildet ist als eine Anordnung eines UP- (72) und eines DOWN- (74) Levelshifterzweiges sowie einer nachgeschalteten Signalauswerteschaltung (76),
mit einem primärseitigen und einem sekundärseitigen Bezugspotential,
wobei der UP- Levelshifterzweig (72) ein Signal an den zugeordneten Eingang der Signalauswerteschaltung (76) angibt, wenn das sekundärseitige Bezugspotential (gnd_sek) nahezu gleich oder höher als das primärseitige Bezugspotential (gnd_pri) ist und der DOWN- Levelshifterzweig (74) ein Signal an den zugeordneten Eingang der Signalauswerteschaltung (76) angibt, wenn das sekundärseitige Bezugspotential (gnd_sek) nahezu gleich oder niedriger als das primärseitige Bezugspotential (gnd_pri) ist und
wobei die Signalauswerteschaltung (76) ein Ausgangssignal (OUT) an den BOT-Treiber (52) übergibt, wenn entweder der UP- (72) oder der DOWN- (74) oder beide Levelshifterzweige ein Signal (OUTp, OUTn) an den jeweils zugeordneten Eingang der Signalauswerteschaltung (76) abgeben.

8. Verfahren nach Anspruch 7,
wobei die Zeitspanne, während der ein Querstrom bei einem Signalwechsel durch den Teilzweig eines Levelshifterzweiges (72, 74) fließt geringer ist als diejenige Zeitspanne, während der das zugehörige Eingangssignal (IN) anliegt.

9. Verfahren nach Anspruch 7,
wobei die Beträge der Gate- Source- Spannungen der Transistoren (M7, M8 und M17, M18), unabhängig von der Differenz zwischen dem primärseitigen (gnd_pri) und sekundärseitigen (gnd_sek) Bezugspotential, auf eine Spannung kleiner oder gleich der sekundärseitigen Betriebsspannung (vdd_sek) begrenzt werden

## Claims

1. Drive circuit (10) with BOT level shifter (70) for transmitting an input signal (IN) from a drive logic (20) with primary-side reference potential to a BOT driver (52) with secondary-side reference potential independent of the primary-side reference potential, wherein the level shifter (70) is formed as an arrangement of an UP (72) and a DOWN (74) level shifter branch and a signal evaluation circuit (76) connected downstream, **characterized**
**in that** the UP level shifter branch (72) is formed from two partial branches, which, for their part, are formed from the series arrangement of two respective n-channel transistors (M1, M3 and M2, M4), wherein the input signal (IN) is present at M1 and the inverted input signal is present at M2, a respective diode (D1 and D2) and two respective p-channel transistors (M5, M7 and M6, M8),
and the DOWN level shifter branch (74) is formed from two partial branches, which, for their part, are formed from the series arrangement of two respective p-channel transistors (M11, M13 and M12, M14), wherein the input signal (IN) is present at M12 and the inverted input signal is present at M11, a respective diode (D11 and D12) and two respective n-channel transistors (M15, M17 and M16, M18).

2. Drive circuit (10) according to Claim 1, wherein, within the level shifter (70), the UP level shifter branch (72) is formed essentially complementarily with respect to the DOWN level shifter branch (74).

3. Drive circuit according to Claim 1,
wherein the output of the UP level shifter branch (72) and the output of the DOWN level shifter branch (74) are connected to the inputs of the signal evaluation circuit (76), and the output (OUT) of the signal evaluation circuit (76) forms the input signal for the BOT driver (52).

4. Drive circuit according to Claim 1,
wherein the drive logic (20), the level shifter (70) and the BOT driver (52) are monolithically integrated.

5. Drive circuit according to Claim 1,
wherein a multivibrator comprising the components (M1 to M8, D1, D2) in the UP level shifter branch (72) is formed by the interconnection of the transistors (M7, M8), and a multivibrator comprising the components (M11 to M18, D11, D12) in the DOWN level shifter branch (74) is formed by the interconnection of the transistors (M17, M18).

6. Drive circuit according to Claim 1,
wherein the gates of the transistors (M5, M6) are connected to the reference potential (gnd_sek) of the BOT driver (52) and the gates of the transistors (M15, M16) are connected to the supply potential (vdd_sek) of the BOT driver (52).

7. Method for transmitting an input signal (IN) from the drive logic (20) to a BOT driver (52) within a drive circuit (10) with BOT level shifter (70) wherein the level shifter (70) is formed as an arrangement of an UP (72) and a DOWN (74) level shifter branch and a signal evaluation circuit (76) connected downstream,
with a primary-side and a secondary-side reference potential,
wherein the UP level shifter branch (72) indicates a signal to the assigned input of the signal evaluation circuit (76) if the secondary-side reference potential (gnd_sek) is virtually identical to or higher than the primary-side reference potential (gnd_pri), and the DOWN level shifter branch (74) indicates a signal to the assigned input of the signal evaluation circuit (76) if the secondary-side reference potential (gnd_sek) is virtually identical to or lower than the primary-side reference potential (gnd_pri) and wherein the signal evaluation circuit (76) transfers an output signal (OUT) to the BOT driver (52) if either the UP (72) or the DOWN (74) or both level shifter branches output a signal (OUTp, OUTn) to the respectively assigned input of the signal evaluation circuit (76).

8. Method according to Claim 7,
wherein the time period during which a shunt current flows in the event of a signal change through the partial branch of a level shifter branch (72, 74) is shorter than that time period during which the associated input signal (IN) is present.

9. Method according to Claim 7,
wherein the magnitudes of the gate-source voltages of the transistors (M7, M8 and M17, M18), independently of the difference between the primary-side (gnd_pri) and secondary-side (gnd_sek) reference potential, are limited to a voltage less than or equal to the secondary-side operating voltage (vdd_sek).

## Revendications

1. Circuit de commande (10) comprenant un dispositif de décalage de niveau de tension BOT (70) pour transmettre un signal d'entrée (IN) d'une logique de commande (20) avec un potentiel de référence côté primaire vers un excitateur BOT (52) avec un potentiel de référence côté secondaire indépendant du potentiel de référence côté primaire, sachant que le dispositif de décalage de niveau de tension (70) est conçu en tant qu'agencement d'une branche du dispositif de décalage de niveau de tension UP (72) et DOWN (74) ainsi que d'un circuit d'évaluation de signal (76) monté en aval,
**caractérisé en ce que**
la branche du dispositif de décalage de niveau de tension UP (72) est formée de deux branches partielles, qui sont formées pour leur part de l'agencement en série de deux transistors à canal n respectifs (M1, M3, respectivement M2, M4), sachant que le signal d'entrée (IN) est placé sur M1 et le signal d'entrée inversé est placé sur M2, d'une diode (D1, respectivement D2) respective et de deux transistors à canal p respectifs (M5, M7, respectivement M6, M8)
et la branche du dispositif de décalage de niveau de tension DOWN (74) est formée de deux branches partielles qui sont formées pour leur part de l'agencement en série de deux transistors à canal p respectifs (M11, M13, respectivement M12, M14), sachant que le signal d'entrée (IN) est placé sur M12 et le signal d'entrée inversé est placé sur M11, d'une diode (D11, respectivement D12) respective et de deux transistors à canal n respectifs (M15, M17, respectivement M16, M18).

2. Circuit de commande (10) selon la revendication 1, dans lequel la branche du dispositif de décalage de niveau de tension UP (72) est formée en étant essentiellement complémentaire à la branche du dispositif de décalage de niveau de tension DOWN (74) à l'intérieur du dispositif de décalage de niveau de tension BOT (70).

3. Circuit de commande selon la revendication 1, dans lequel la sortie de la branche du dispositif de décalage de niveau de tension UP (72) et la sortie de la branche du dispositif de décalage de niveau de tension DOWN (74) sont reliées aux entrées du circuit d'évaluation de signal (76) et la sortie (OUT) du circuit d'évaluation de signal (76) forme le signal d'entrée pour l'excitateur BOT (52).

4. Circuit de commande selon la revendication 1, dans lequel la logique de commande (20), le dispositif de décalage de niveau de tension BOT (70) et l'excitateur BOT (52) sont intégrés de façon monolithique.

5. Circuit de commande selon la revendication 1, dans lequel la circuiterie des transistors (M7, M8) forme une bascule, composée des composants (M1 à M8, D1, D2) dans la branche du dispositif de décalage de niveau de tension UP (72), et la circuiterie des transistors (M17, M18) forme une bascule, composée des composants (M11 à M18, D11, D12) dans la branche du dispositif de décalage de niveau de tension DOWN (74).

6. Circuit de commande selon la revendication 1, dans lequel les portes des transistors (M5, M6) sont reliées au potentiel de référence (gnd_sek) de l'excitateur BOT (52) et les portes des transistors (M15, M16) sont reliées au potentiel d'alimentation (vdd_sek) de l'excitateur BOT (52).

7. Procédé de transmission d'un signal d'entrée (IN) de la logique de commande (20) à un excitateur BOT (52) à l'intérieur d'un circuit de commande (10) avec un dispositif de décalage de niveau de tension BOT (70), sachant que le dispositif de décalage de niveau de tension (70) est conçu en tant qu'agencement d'une branche du dispositif de décalage de niveau de tension UP (72) et DOWN (74) ainsi que d'un circuit d'évaluation de signal (76) monté en aval,
comprenant un potentiel de référence côté primaire et côté secondaire, sachant que la branche du dispositif de décalage de niveau de tension UP (72) fournit un signal à l'entrée correspondante du circuit d'évaluation de signal (76) lorsque le potentiel de référence côté secondaire (gnd_sek) est presque égal ou supérieur au potentiel de référence côté primaire (gnd_pri) et la branche de décalage de niveau de tension DOWN (74) fournit un signal à l'entrée correspondante du circuit d'évaluation de signal (76) lorsque le potentiel de référence côté secondaire (gnd_sek) est presque égal ou inférieur au potentiel de référence côté primaire (gnd_pri) et
dans lequel le circuit d'évaluation de signal (76) transmet un signal de sortie (OUT) à l'excitateur BOT (52) lorsque soit la branche du dispositif de décalage de niveau de tension UP (72) ou DOWN (74) ou bien les deux, fournissent un signal (OUTp, OUTn) à l'entrée respective correspondante du circuit d'évaluation de signal (76).

8. Procédé selon la revendication 7,
dans lequel l'intervalle de temps pendant lequel une composante transversale du courant s'écoule à travers la branche partielle d'une branche du dispositif de décalage de niveau de tension (72, 74) lors d'un changement de signal est plus étroit que l'intervalle de temps pendant lequel le signal d'entrée (IN) correspondant est présent.

9. Procédé selon la revendication 7,
dans lequel les valeurs des tensions Gate-Source des transistors (M7, M8 et M17, M18), indépendamment de la différence entre le potentiel de référence côté primaire (gnd_pri) et côté secondaire (gnd_sek), sont limitées à une tension inférieure ou égale à la tension de service côté secondaire (vdd_sek).
